# FASCICULE DE BREVET EUROPEEN

(11) **EP 3 841 618 B1**
(45) Date de publication et mention de la délivrance du brevet: **24.08.2022**
(21) Numéro de dépôt: 19823793.5
(22) Date de dépôt: 09.10.2019
(51) Int. Cl.: H01L 31/18, H01L 31/0224

(54) **REALISATION DE ZONES DOPEES N+ ET N++ POUR CELLULE SOLAIRE**
ERZEUGUNG VON N+- UND N++-DOTIERTEN BEREICHEN FÜR EINE SOLARZELLE
CREATION OF N+ AND N++ DOPED REGIONS FOR A SOLAR CELL

(30) Priorité: 12.10.2018 FR 1859498
(43) Date de publication de la demande: 30.06.2021
(73) Titulaire: COMMISSARIAT À L'ÉNERGIE ATOMIQUE ET AUX ÉNERGIES ALTERNATIVES, 75015 Paris (FR)
(72) Inventeur: LANTERNE, Adeline, 38054 GRENOBLE CEDEX 09 (FR); CABAL, Raphaël, 38054 GRENOBLE CEDEX 09 (FR); LORFEUVRE, Coralie, 38054 GRENOBLE CEDEX 09 (FR); DESRUES, Thibaut, 38054 GRENOBLE CEDEX 09 (FR); PIROT, Marc, 38054 GRENOBLE CEDEX 09 (FR)
(74) Mandataire: Brevalex
(86) Numéro de dépôt international: PCT/FR2019/052390
(87) Numéro de publication internationale: WO 2020/074824

(56) Documents cités:
- EP-A2- 2 608 280
- US-A1- 2009 142 875
- HALLAM BRETT ET AL: "Efficiency enhancement of i-PERC solar cells by implementation of a laser doped selective emitter", SOLAR ENERGY MATERIALS AND SOLAR CELLS, vol. 134, 5 décembre 2014 (2014-12-05), pages 89-98, XP029134946, ISSN: 0927-0248, DOI: 10.1016/J.SOLMAT.2014.11.028 cité dans la demande
- ADELINE LANTERNE ET AL: "Implanted selective emitter solar cells by laser thermal annealing", AIP CONFERENCE PROCEEDINGS, 1 janvier 2012 (2012-01-01), pages 131-134, XP055595470, NEW YORK, US ISSN: 0094-243X, DOI: 10.1063/1.4766507

## Description

### DOMAINE TECHNIQUE ET ART ANTÉRIEUR

La présente invention a trait au domaine des structures semiconductrices dopées notamment dans le photovoltaïque, et plus particulièrement à celui de structures comportant des zones adjacentes dopées N et ayant des concentrations en dopants et/ou profils de dopage différents.

Dans une cellule solaire il est courant de réaliser, sur une même face, des zones dopées avec des résistances carrées respectives différentes.

Le document « Efficiency enhancement of i-PERC solar cells by implementation of a laser doped selective emitter» Hallam, Solar Energy Materials&SolarCells 134(2015)89-98, présente par exemple une cellule solaire dont la face avant texturée comporte des premières zones fortement dopées N++ permettant de réaliser un contact ohmique avec une électrode sous forme de pistes métalliques, et des secondes zones dopées N+, destinées à former la zone exposée au rayonnement solaire et dont le dopage est plus faible notamment afin d'éviter les recombinaisons électrons-trous par recombinaisons Auger.

Différentes techniques de dopage existent pour la réalisation des cellules solaires. À part la diffusion gazeuse à haute température traditionnellement utilisé pour son faible coût, le dopage par implantation ionique associé à un recuit thermique présente l'avantage d'être plus uniforme et il est très reproductible, il permet de plus un dopage « simple face » qui peut simplifier les procédés de fabrication, ainsi qu'une plus grande flexibilité sur les profils de concentration en dopants obtenus.

Pour réaliser des zones dopées avec des profils de concentration en dopants différents, une méthode consiste à réaliser plusieurs implantations. Pour au moins une de ces implantations, on utilise un masque avec une ou plusieurs ouvertures à travers lesquelles on réalise un dopage des zones auxquelles on souhaite conférer la concentration en dopants la plus forte. Le masque permet alors de protéger les zones adjacentes prévues avec une concentration en dopants plus faible. Cependant l'ajout d'une seconde étape d'implantation (étape coûteuse dans le procédé de fabrication des cellules) est un fort désavantage pour l'industrialisation de ce procédé.

Une autre méthode décrite dans le document EP 2 608 280 A2 et permettant de se passer d'un masque, consiste à utiliser des recuits différents pour réaliser des zones dopées N+ et N++ sur une même face et en particulier d'effectuer un recuit laser localisé afin d'activer une plus grande dose de dopants dans la zone dopée N++, cette dernière s'étendant également davantage en profondeur. Un tel recuit laser a toutefois tendance à dégrader la face exposée au laser, et en particulier lorsque cette face comporte une zone texturée.

US 2009/142875 A1 divulgue un procédé de réalisation d'une structure semi-conductrice pour cellule solaire avec des régions dopées N ayant des profils et/ou des concentrations en dopants différentes, comprenant l'implantation d'une espèce dopante, en particulier du phosphore, dans une zone superficielle d'un substrat semi-conducteur.

Il se pose donc le problème de trouver un nouveau procédé de réalisation de zones adjacentes dopées par implantation ionique ayant des profils et concentrations différentes et qui soit amélioré vis-à-vis d'inconvénients mentionnés ci-dessus.

### EXPOSÉ DE L'INVENTION

Un mode de réalisation de la présente invention prévoit un procédé de réalisation d'une structure semi-conductrice pour cellule solaire avec des régions dopées N ayant des profils et/ou des concentrations en dopants différentes, comprenant les étapes suivantes
- implanter une espèce dopante, en particulier du Phosphore, dans une zone superficielle d'un substrat semi-conducteur,
- puis la formation sur au moins une première région de la zone superficielle une couche barrière, tandis qu'au moins une deuxième région de la zone superficielle adjacente de la première région est dévoilée et n'est pas recouverte par la couche barrière,
- effectuer au moins un recuit d'activation de dopants de la zone superficielle de sorte à réaliser un dopage N de cette zone superficielle, tandis que la couche barrière est conservée sur la première région et que la deuxième région est dévoilée et n'est pas recouverte par la couche barrière, ce qui conduit à une désorption de l'espèce dopante au niveau de la deuxième région, la couche barrière conservée sur la première région empêchant ou limitant une désorption de l'espèce dopante au niveau de la première région.

Ainsi, pour réaliser la deuxième région dopée on utilise ici le phénomène de désorption de Phosphore que l'Homme du Métier cherche normalement à éviter, tandis que, pour réaliser la première région dopée on freine ou on bloque ce phénomène via la couche barrière de diffusion.

Un tel procédé ne nécessite pas un nombre d'étapes important et permet de réaliser des régions adjacentes dopées N avec des profils et/ou concentrations différentes ce, sans dégrader la face dopée. Par ailleurs, un tel procédé peut être mis en œuvre en utilisant qu'une seule étape d'implantation.

Avantageusement, la première région et la deuxième région peuvent être réalisées sans faire appel à un recuit laser localisé spécifique susceptible de dégrader la face du substrat où l'on forme ces régions dopées.

À l'issue du recuit d'activation, la première région dopée peut être une région dopée N++, tandis que la deuxième région est une région dopée N+. Une différence de résistance carré d'au moins 5 ohm/carré peut être avantageusement obtenue entre la première région dopée et la deuxième région dopée.

Selon un mode de réalisation, on prévoit une couche barrière à base de matériau diélectrique, en particulier à base de nitrure de silicium ou d'oxyde de silicium, ou d'oxynitrure de silicium. Dans ce cas, la couche barrière peut être avantageusement utilisée comme couche de passivation. Cette couche de passivation peut être conservée dans la suite du procédé de fabrication.

Typiquement, la couche barrière a une épaisseur comprise entre 5 nm et 150 nm.

De préférence, la couche barrière est déposée à basse température, en particulier inférieure à 450°C, de préférence inférieure à 300°C et préférentiellement comprise entre 150°C et 250°C. Un dépôt à basse température de la couche barrière permet d'effectuer ensuite le recuit thermique d'activation selon une gamme de température et de durée plus importantes et notamment de libérer ainsi les contraintes liées au choix de paramètres de recuit nécessaires à l'obtention d'une désorption du phosphore suffisante pour obtenir l'écart en résistance carré voulu.

Selon une possibilité de mise en œuvre, la zone superficielle s'étend contre une face texturée du substrat dotée de motifs en relief. Le procédé défini plus haut permet de réaliser la première région et la deuxième région sans endommager cette face texturée.

Avantageusement, l'implantation est réalisée par immersion plasma (PIII), ce qui permet de réaliser un dopage à plus faible coût que l'implantation classique par faisceaux d'ions et permet d'implanter avec une très forte concentration en dopant au niveau de la surface, en particulier supérieure à 1×10²⁰ at/cm³, ce qui peut avantageusement augmenter le phénomène de désorption du phosphore lors du recuit.

Le procédé défini plus haut s'intègre au procédé de fabrication d'une cellule solaire.

Une fois avoir effectué le recuit d'activation des dopants, le procédé de fabrication de la cellule peut comprendre en outre la formation d'un contact sur ladite première région, typiquement dopée N++.

Une portion de la couche barrière peut être partiellement conservée et servir alors avantageusement de passivation du contact.

### BRÈVE DESCRIPTION DES DESSINS

D'autres caractéristiques et avantages de l'invention ressortiront plus clairement à la lecture de la description suivante et en référence aux dessins annexés, donnés à titre uniquement illustratif et nullement limitatifs.
Les figures 1A-1F servent à illustrer un exemple de procédé de réalisation de zones dopées au phosphore de concentration en dopants et profils différents dans une structure semi-conductrice de cellule solaire, et ce en utilisant une couche barrière réalisée de manière localisée après dopage et avant activation de dopants ;
La figure 2 sert à illustrer l'impact de la température de dépôt de la couche barrière sur l'effet de désorption du phosphore en fonction des conditions de recuit d'activation des dopants ;
Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation de la structure tels que « avant », « supérieure », « arrière », « inférieure », « latérale », s'appliquent en considérant que la structure est orientée de la façon illustrée sur les figures.

### EXPOSÉ DÉTAILLÉ DE MODES DE RÉALISATION PARTICULIERS

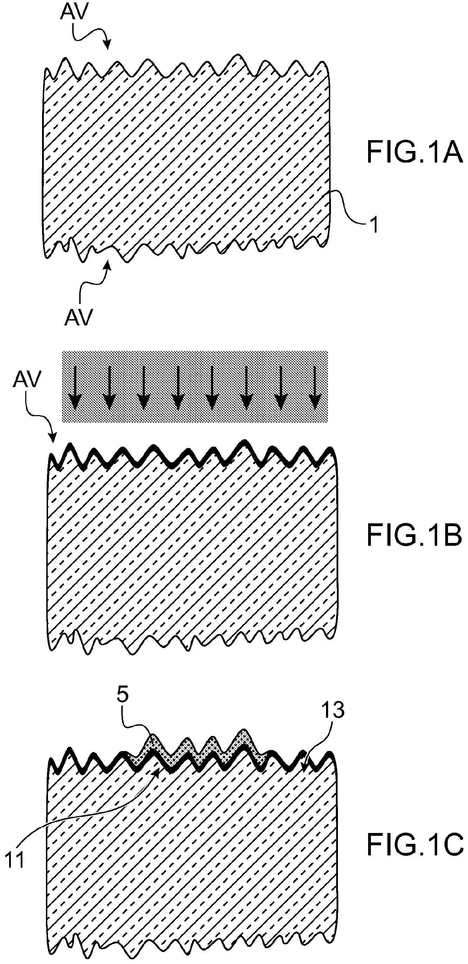

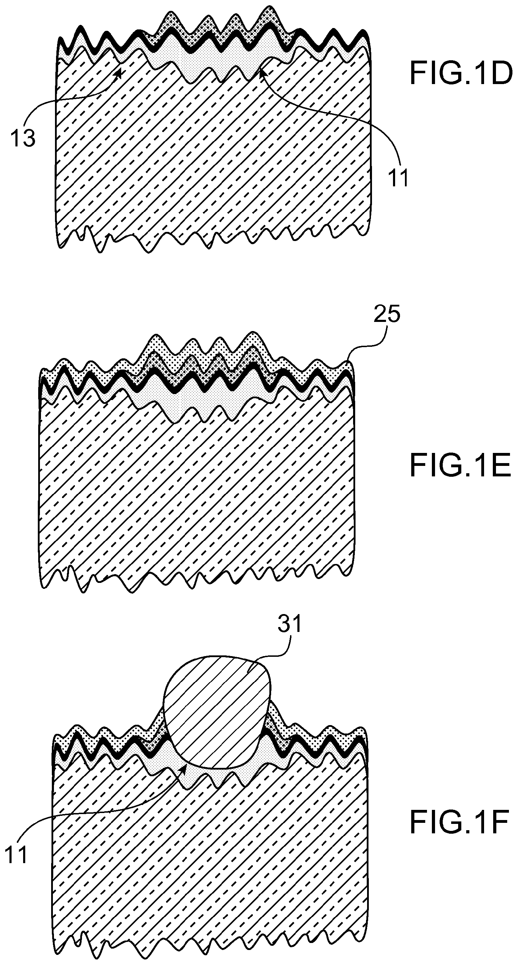

Un exemple de procédé de réalisation, dans une cellule photovoltaïque, de zones dopées adjacentes avec des concentrations et/ou profils différents va à présent être décrit en liaison avec les figures 1A-1F.

On réalise ici des zones dopées de type N, autrement dit avec un dopage qui consiste à produire un excès d'électrons.

Le matériau de départ de ce procédé peut être un substrat 1 à base de matériau semi-conducteur cristallin typiquement en silicium qui peut être monocristallin, multi-cristallin ou polycristallin. Le substrat 1 de départ peut être déjà dopé selon un dopage de type N ou P.

Afin de diminuer la réflectivité de la surface de la cellule et d'augmenter le chemin optique de la lumière dans la cellule, une texturation d'au moins une face du substrat 1 peut être prévue. Cette opération permet de former en surface un relief, par exemple sous forme de motifs pyramidaux micrométriques. La texturation est typiquement réalisée par action mécanique ou par attaque chimique, par exemple en plaçant le substrat 1 dans un bain contenant une solution de KOH.

Dans l'exemple illustré sur la figure 1A, une texturation du substrat 1 est mise en œuvre aussi bien au niveau de sa face avant AV que de sa face arrière AR. Par « face avant » on entend dans cet exemple une face principale du substrat 1 qui est destinée à être directement exposée au soleil, tandis que la « face arrière » est la face principale opposée à la face avant.

La figure 1B illustre une étape ultérieure de dopage d'une zone du substrat 1 qui s'étend le long d'une première de ses faces principales AV, AR. Le dopage de la première face ou face avant AV est typiquement réalisé par implantation. Une telle implantation est de préférence uniforme en face avant AV.

De manière avantageuse, le dopage est effectué par implantation par immersion plasma (PIII pour « Plasma Immersion Ion Implantation »). Cette technique qui utilise un plasma comme source d'espèce permet de réaliser une implantation à coût réduit. Ce type d'implantation dit « multi-énergétique » conduit à un profil de concentration en dopant maximal au niveau de la surface. Elle permet ainsi d'obtenir une très forte concentration en dopants au niveau de la surface après implantation, pouvant ainsi augmenter le phénomène de désorption du phosphore.. Typiquement, les concentrations en dopants au niveau de la surface après implantation sont supérieures à 1×10²⁰ at/cm³.

Dans cet exemple de réalisation, le dopage de type N de la première face est effectué au moyen de Phosphore. L'implantation peut être dans ce cas réalisée en présence d'un précurseur gazeux de type phosphine PH₃.

L'implantation peut être en particulier prévue avec une dose par exemple comprise entre 5×10¹⁴ at/cm² et 2×10¹⁶ at/cm² et une tension d'accélération comprise par exemple entre 100V et 10 kV. La dose est ici donnée dans le cas d'une implantation PIII à partir de gaz PH₃, celle-ci comprenant à la fois les ions du plasma contenant du Phosphore et les ions hydrogène.

Une fois l'implantation réalisée, un phénomène de désorption de l'espèce dopante implantée peut avoir lieu. En particulier, le Phosphore implanté peut désorber et réagir avec l'oxygène environnant pour former une couche d'oxyde de Phosphore.

Selon une particularité de l'invention, on évite ou on limite ce phénomène de désorption de Phosphore au niveau d'au moins une région donnée localisée de la première face AV.

Pour cela, on forme de manière localisée, une couche barrière sur cette région donnée. On prévoit de préférence un temps d'attente, entre l'issue de l'étape d'implantation et la réalisation de cette couche barrière, le plus court possible. Avantageusement, ce temps d'attente est inférieur à 24 heures et de préférence inférieur à 1 heure.

La figure 1C illustre une étape de formation de la couche barrière 5 sur une région 11 de la première face AV dopée par implantation et à laquelle on prévoit de conférer une concentration forte en dopants, en particulier selon un dopage N++. Par dopage N++ ou concentration « forte » en dopants, on entend ici une concentration maximale en dopants actifs typiquement supérieure à 1×10¹⁹ at/cm³ typiquement compris entre 1×10²⁰ at/cm³ et 5×10²⁰ at/cm³.

La couche barrière 5 est ainsi agencée sur une région 11 de la face AV du substrat 1 au niveau de laquelle on souhaite éviter ou tout au moins limiter un phénomène de désorption de dopants. Au moins une autre région 13 de la face AV adjacente de la région 11 est quant à elle dévoilée et n'est pas recouverte par cette couche barrière 5. Au niveau de cette autre région 13, la désorption de phosphore n'est donc pas freinée ou bloquée.

La couche barrière 5 peut être formée en déposant un matériau au travers une ou plusieurs ouverture(s) d'un masque apposé ou formé sur la face avant AV. Le masque (non représenté) peut être par exemple en graphite, ou en silicium, ou en un matériau céramique, ou d'un matériau métallique.

Une autre possibilité de réalisation de la couche barrière 5 est un dépôt pleine plaque de matériau, c'est à dire recouvrant toute la face avant AV. Dans ce cas, on forme ensuite un ou plusieurs motifs dans la couche déposée pleine plaque. Le(s) motif(s) peu(ven)t être formé(s) par écriture directe, sans utiliser de masque, par exemple en employant un laser ou une technique de lithographie.

La couche barrière 5 peut être en un matériau ou un empilement de plusieurs matériaux. Par exemple, la couche barrière 5 peut être à base d'oxyde de silicium (SiOₓ), ou de nitrure de silicium (SiN), ou de de nitrure de silicium incorporant de l'oxygène, ou d'oxynitrure de silicium. Selon un mode particulier de réalisation, elle est constituée par un matériau diélectrique ou un empilement de matériaux diélectriques, tels que l'oxyde de silicium, le nitrure de silicium ou un oxynitrure de silicium.

Avantageusement, on prévoit une couche barrière 5 en matériau diélectrique afin que certaines zones de celle-ci puisse servir ultérieurement de passivation. La couche barrière 5 a typiquement une épaisseur comprise entre 5 nm et 150 nm.

La couche barrière 5 est de préférence prévue en un matériau et une épaisseur de manière à bloquer ou ralentir la diffusion de phosphore. L'Homme du métier spécialiste des implantations saura choisir le matériau et l'épaisseur de la couche barrière de manière à bloquer ou ralentir la diffusion des atomes.

Par exemple, la couche barrière 5 est une couche de nitrure de silicium SiNₓ présentant une épaisseur qui peut être comprise entre 5 nm et 150nm, de préférence entre 10 et 100nm et, par exemple, de l'ordre 70 nm.

Avantageusement, on réalise le dépôt de la couche barrière 5 par une technique PECVD (pour « Plasma-Enhanced Chemical Vapor Deposition », en francais « dépôt chimique en phase vapeur assisté par plasma »).

De préférence, on prévoit de réaliser le dépôt de la couche barrière 5 à basse température, en particulier afin d'éviter une modification de l'état de surface de la région 13 en regard de laquelle on ne souhaite pas conserver ou réaliser la couche barrière 5 et d'éviter ainsi de limiter le phénomène de désorption dans cette zone.

Lorsque la couche barrière 5 est en nitrure de silicium, on choisit typiquement une température de dépôt inférieure à 450°C et de préférence inférieure à 300°C et préférentiellement comprise entre 150°C et 250°C.

Avantageusement, la couche barrière 5 lorsqu'elle est en nitrure de silicium peut être déposée à une température de l'ordre de 200°C afin de pouvoir réaliser des régions 11, 13 dopées aux profils et/ou concentrations différent(e)s, en particulier N+ et N++, ayant des écarts significatifs en termes de résistance carré et ce, sur une gamme très importante de conditions de recuit d'activation.

Comme indiqué précédemment, à l'issue de la réalisation de la couche barrière 5, au moins une autre région 13 de la première face AV est découverte et non recouverte par la couche barrière 5, cette autre région 13 correspondant donc à une portion de la zone superficielle de la face avant AV pour laquelle on souhaite favoriser le phénomène de désorption de dopants. L'autre région 13 est ainsi une portion de la zone superficielle de la face avant AV à laquelle on souhaite conférer un profil et/ou une concentration différente de celle de la région donnée 11 protégée par la couche barrière 5. Dans cet exemple de réalisation particulier, la région 13 non recouverte est une portion que l'on souhaite doper N+. Par dopage N+, on entend ici une concentration maximale en dopants actifs typiquement inférieure à 4×10²⁰ at/cm³ typiquement compris entre 8×10¹⁹ at/cm³ et 3×10²⁰ at/cm³.

Ensuite, on procède à au moins un recuit thermique prévu à une température et selon une durée adaptées de sorte à réaliser une activation des dopants phosphore. Le recuit d'activation peut être réalisé à une température comprise par exemple entre 780°C et 1100°C et selon une durée prévue par exemple entre 1s min et 120 min.

Différents profils de recuits peuvent être mis en œuvre. On peut par exemple effectuer un recuit de type « classique», c'est à dire ayant un profil avec une montée en température lente, par exemple de l'ordre de 10°C/min et un maintien en température pendant une durée d'au moins une dizaine de minutes. Un autre exemple de réalisation prévoit d'utiliser un recuit de type « spike », autrement dit avec un profil de température en forme de pic c'est à dire avec une montée en température rapide, par exemple de l'ordre de quelques seconde tout de suite suivie d'une baisse de température rapide et de l'ordre de quelques secondes.

On peut être amené à adapter les conditions de recuit d'activation, en particulier en termes de température et de durée en fonction de la température à laquelle la couche barrière 5 a été déposée et en fonction du profil de concentration en dopant souhaité pour les zones dopées N+ et N++.

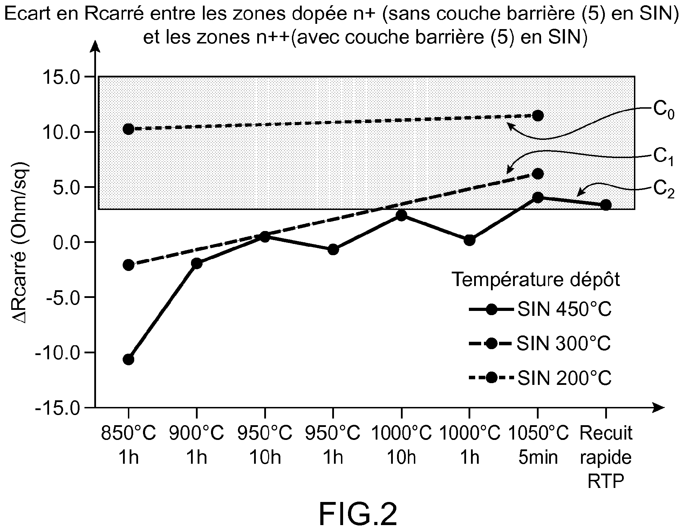

Sur la figure 2 les courbes C0, C1, C2 sont toutes représentatives d'une différence de résistance carré à l'issue du recuit d'activation, entre une région 11 recouverte par une couche barrière 5 en nitrure et une autre région 13 non recouverte par cette couche barrière 5 en fonction de différentes conditions de recuit d'activation pour un condition d'implantation PIII donnée à partir du gaz précurseur PH3. Les courbes C0, C1, C2 représentent une variation d'écart de résistance respectivement pour, une température de dépôt de la couche barrière de 200°C, une température de dépôt de la couche barrière de 300°C, une température de dépôt de 450°C. On constate ainsi qu'en dessous d'une certaine température de dépôt de la couche barrière, on peut, pour des conditions de recuit d'activation très variables, obtenir un écart de résistance carré suffisant, c'est-à-dire typiquement supérieur à 5Ω/carré.

À l'issue de l'activation, on obtient une région 11 fortement dopée sous la couche barrière 5, par exemple une région dopée N++ avec une concentration en dopants qui peut être comprise entre 1×10²⁰ at/cm³ et 5×10²⁰ at/cm³, et une autre région 13 moins dopée que la région 11 donnée, en particulier dopée N+. La région 13 plus faiblement dopée, peut avoir par une concentration de dopants comprise entre 8×10¹⁹ at/cm³ et 3×10²⁰ at/cm³.

Les profils de dopage différents obtenus à l'issue du recuit d'activation entre d'une part la région 11 masquée et d'autre part la ou les autres région(s) 13 non-masquée(s) peuvent être mesurés par une technique de profilage électrochimique de capacité-tension ECV (acronyme de « Electrochemical Capacitance-Voltage ») permettant d'obtenir un profil de concentration de porteurs actifs dans la couche semi-conductrice du substrat 1, ou bien par une technique de type SIMS (pour « Secondary Ion Mass Spectrometry »). Les niveaux de dopage respectifs sont également quantifiables par le biais d'une mesure électrique de type 4 pointes.

La région 11 recouverte par la couche barrière 5 et qui présente un dopage plus conséquent peut être prévue pour réaliser une prise de contact.

On peut ensuite former sur la première face AV du substrat 1 une couche 25 à base d'un matériau, de préférence diélectrique, et d'épaisseur prévus de manière à servir d'anti-reflet. La couche antireflet 25, par exemple en SiNx, permet de réduire les pertes optiques liées aux réflexions du rayonnement lumineux et d'optimiser l'absorption du rayonnement lumineux par le substrat 1. De manière optionnelle, une couche antireflet 25 en SiNₓ, peut être également utilisée comme couche dédiée à la passivation.

Puis (figure 1F), on forme au moins une électrode 31 métallique sur la première face AV, et en particulier en contact avec la région 11 dopée N++. Typiquement, cette étape comporte une métallisation qui peut être réalisée par sérigraphie. L'électrode 31 peut être formée d'une couche d'oxyde conducteur transparent tel que de l'ITO sur laquelle repose une couche métallique, par exemple à base d'Ag.

L'électrode 31 peut être formée par le dépôt par sérigraphie d'une pâte métallique par exemple à base d'Argent suivit d'un recuit du contact. Le dépôt métallique et la région 11 sur laquelle il est réalisé peut prendre la forme d'une grille. Le recuit du contact peut se faire par exemple dans un four à lampe infra-rouge et peut permettre à la pâte à base d'Argent de traverser la couche antireflet 25 et la couche barrière 5 si celle-ci est conservée.

En variante, on peut réaliser l'électrode 31, en effectuant une ouverture à travers la couche antireflet 25 et la couche barrière 5 dans le cas où celle-ci a été conservée à travers laquelle on effectue au moins un dépôt de matériau métallique.

Lorsque la couche barrière 5 est en matériau électriquement isolant elle peut former une passivation.

Le procédé qui a été décrit précédemment s'applique à la fabrication de cellules solaires incluant un dopage sélectif au phosphore, pouvant être présent dans les cellules en silicium dotées d'un champ de surface arrière BSF (Back Surface Field) réalisé par un dépôt d'aluminium, cellule de type AI-BSF, les cellules de type PERC (« Passivated Emitter and Rear Cell » ou « Passivated Emitter and Rear Contact ») ou de type PERT (« Passivated Emitter, Rear Totally diffused »).

Un tel procédé peut toutefois être également employé afin de réaliser des zones de dopages et/ou profils différents, en particulier des zones adjacentes N++ et N+ dans un autre type de dispositif, et par exemple dans un dispositif microélectronique ou optoélectronique.

## Revendications

1. Procédé de réalisation d'une structure semi-conductrice pour cellule solaire avec des régions dopées N ayant des profils et/ou des concentrations en dopants différentes, comprenant les étapes suivantes :
- implanter une espèce dopante, en particulier du Phosphore, dans une zone superficielle d'un substrat (1) semi-conducteur,
- puis la formation sur au moins une première région (11) de la zone superficielle une couche barrière (5), tandis qu'au moins une deuxième région (13) de la zone superficielle adjacente de la première région est dévoilée et n'est pas recouverte par la couche barrière,
- effectuer au moins un recuit d'activation de dopants de la zone superficielle de sorte à réaliser un dopage N de cette zone superficielle, tandis que la couche barrière (5) est conservée sur la première région (11) et que la deuxième région est dévoilée et n'est pas recouverte par la couche barrière, ce qui conduit à une désorption de l'espèce dopante au niveau de la deuxième région (13), la couche barrière conservée sur la première région (11) empêchant ou limitant une désorption de l'espèce dopante au niveau de la première région (11).

2. Procédé selon la revendication 1, dans lequel la couche barrière (5) est à base d'un matériau diélectrique ; en particulier à base de nitrure de silicium ou d'oxyde de silicium, ou d'oxynitrure de silicium.

3. Procédé selon la revendication 2, dans lequel la couche barrière a une épaisseur comprise entre 5 nm et 150 nm.

4. Procédé selon l'une des revendications 1 à 3, dans lequel la couche barrière est déposée à température inférieure à 450°C, de préférence inférieure à 300°C

5. Procédé selon l'une des revendications 1 à 4, dans lequel la zone superficielle s'étend contre et dans une face (AV) texturée du substrat (1) dotée de motifs en relief.

6. Procédé selon l'une des revendications 1 à 5, dans lequel l'implantation est réalisée par immersion plasma (PIII).

7. Procédé selon l'une des revendications 1 à 6, dans lequel à l'issue dudit au moins un recuit d'activation, la première région est dopée N+, la deuxième région est dopée N++.

8. Procédé selon l'une des revendications 1 à 7, dans lequel à l'issue dudit au moins un recuit d'activation, la différence entre la résistance carré de la première région et la résistance carré de la deuxième région est d'au moins 5 ohm/carré.

9. Procédé de réalisation d'une cellule solaire comprenant :
- la mise en œuvre d'une structure suivant un procédé selon l'une des revendications 1 à 8, puis,
- la formation d'un contact (31) sur ladite première région (11).

## Patentansprüche

1. Verfahren zur Herstellung einer Halbleiterstruktur für Solarzelle mit N-dotierten Bereichen, die unterschiedliche Dotierungsprofile und/oder - konzentrationen haben, umfassend die folgenden Schritte:
- Implantieren einer dotierenden Spezies, insbesondere von Phosphor, in einen Oberflächenbereich eines Halbleitersubstrats (1),
- dann Bilden einer Sperrschicht (5) auf mindestens einer ersten Region (11) des Oberflächenbereichs, wohingegen mindestens eine zweite Region (13) des Oberflächenbereichs, die zu der ersten Region benachbart ist, frei ist und nicht von der Sperrschicht bedeckt ist,
- Durchführen mindestens eines Aktivierungstemperns von Dotierungsmitteln des Oberflächenbereichs, so dass eine N-Dotierung dieses Oberflächenbereichs durchgeführt wird, wohingegen die Sperrschicht (5) auf der ersten Region (11) beibehalten wird und die zweite Region frei ist und nicht von der Sperrschicht bedeckt ist, was zu einer Desorption der dotierenden Spezies im Bereich der zweiten Region (13) führt, wobei die auf der ersten Region (11) beibehaltene Sperrschicht eine Desorption der dotierenden Spezies im Bereich der ersten Region (11) verhindert oder begrenzt.

2. Verfahren nach Anspruch 1, wobei die Sperrschicht (5) auf der Basis eines dielektrischen Materials ist; insbesondere auf der Basis von Siliciumnitrid oder von Siliciumoxid oder von Siliciumoxinitrid.

3. Verfahren nach Anspruch 2, wobei die Sperrschicht eine Dicke hat, die zwischen 5 nm und 150 nm liegt.

4. Verfahren nach einem der Ansprüche 1 bis 3, wobei die Sperrschicht bei einer Temperatur von unter 450 °C, vorzugsweise von unter 300 °C, aufgebracht wird.

5. Verfahren nach einem der Ansprüche 1 bis 4, wobei sich der Oberflächenbereich gegen und in einer texturierten Fläche (AV) des Substrats (1) erstreckt, die mit Reliefmotiven dotiert ist.

6. Verfahren nach einem der Ansprüche 1 bis 5, wobei die Implantierung durch Plasmaimmersion (PIII) durchgeführt wird.

7. Verfahren nach einem der Ansprüche 1 bis 6, wobei nach Abschluss des mindestens einen Aktivierungstemperns die ersten Region N+-dotiert ist, die zweite Region N++-dotiert ist.

8. Verfahren nach einem der Ansprüche 1 bis 7, wobei nach Abschluss des mindestens einen Aktivierungstemperns der Unterschied zwischen dem Quadratwiderstand der ersten Region und dem Quadratwiderstand der zweiten Region mindestens 5 Ohm/Quadrat beträgt.

9. Verfahren zur Herstellung einer Solarzelle, umfassend:
- das Herstellen einer Struktur nach einem Verfahren nach einem der Ansprüche 1 bis 8, dann
- das Bilden eines Kontakts (31) auf der ersten Region (11).

## Claims

1. Method of forming a semiconductor structure for a solar cell with N-doped regions having different concentrations and/or profiles of dopants, comprising the following steps:
- implanting a doping species, in particular Phosphorus, in a surface zone of a semiconductor substrate (1),
- then forming over at least one first region (11) of the surface zone a barrier layer (5), while at least one second region (13) of the surface zone adjacent to the first region is revealed and is not covered by the barrier layer,
- performing at least one annealing operation for activating dopants of the surface zone so as to produce N-doping of that surface zone, while the barrier layer (5) is kept on the first region (11) and the second region is revealed and is not covered by the barrier layer, which leads to desorption of the doping species at the location of the second region (13), the barrier layer kept on the first region (11) preventing or limiting desorption of the doping species at the location of the first region (11).

2. Method according to claim 1, in which the barrier layer (5) comprises a dielectric material; in particular silicon nitride based or silicon oxide based or silicon oxynitride based.

3. Method according to claim 2, in which the barrier layer has a thickness comprised between 5 nm and 150 nm.

4. Method according to one of claims 1 to 3, in which the barrier layer is deposited at a temperature less than 450°C, preferably less than 300°C.

5. Method according to one of claims 1 to 4, in which the surface zone extends against and within a textured face (AV) of the substrate (1) provided with pattern motifs in relief.

6. Method according to one of claims 1 to 5, in which the implantation is carried out by plasma immersion (Pill).

7. Method according to one of claims 1 to 6, in which further to said at least one activating annealing operation, the first region is N+ doped, the second region is N++ doped.

8. Method according to one of claims 1 to 7, in which further to said at least one activating annealing operation, the difference between the sheet resistance of the first region and the sheet resistance of the second region is at least 5 ohm/square.

9. Process for producing a solar cell comprising:
- employing a structure according to a method according to one of claims 1 or 8, then
- forming a contact (31) on said first region (11).
